(19)

**Europäisches Patentamt**

**European Patent Office**

**Office européen des brevets**

(11) **EP 4 734 140 A1**

(12) **EUROPEAN PATENT APPLICATION**

(43) Date of publication:
29.04.2026 Bulletin 2026/18

(21) Application number: 25207283.0

(22) Date of filing: 07.10.2025

(51) International Patent Classification (IPC):
*H01H 11/00* (2006.01)  *H01H 71/04* (2006.01)
*G06N 7/01* (2023.01)  *H02H 1/00* (2006.01)
*G06N 20/00* (2019.01)

(52) Cooperative Patent Classification (CPC):
**H01H 11/0062; G06N 7/01; G06N 20/00;**
**H01H 71/04;** H01H 2071/042; H01H 2071/044;
H02H 1/0092

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: 22.10.2024 US 202418923155

(71) Applicant: **Schneider Electric USA, Inc.**
**Andover, MA 01810 (US)**

(72) Inventors:
• **Cui, Changxing**
  **Raleigh, NC (US)**
• **Diaz, Mauricio**
  **Monterrey (MX)**
• **Ortiz del Angel, Carlos Andres**
  **Monterrey (MX)**
• **Zamarripa, Ezequiel Salas**
  **Monterrey (MX)**

(74) Representative: **Manitz Finsterwald**
**Patent- und Rechtsanwaltspartnerschaft mbB**
**Martin-Greif-Straße 1**
**80336 München (DE)**

(54) **ELECTRICAL CIRCUIT BREAKER EVENT DETECTION**

(57) Embodiments described herein provide techniques for detecting Electrical Circuit Breaker (ECB) events. Embodiments receive Electrical Circuit Breaker (ECB) handle motion data from a sensor, generate an encoded motion vector using one or more motion characteristics from the received ECB handle motion data, generate a probability distribution of ECB events from the encoded motion vector and the one or more motion characteristics using a trained Machine Learning (ML) model, generate a prediction of an electrical breaker movement event based on the generated probability distribution of ECB events by identifying an ECB event with the highest probability from the trained ML model, and transmit a signal, upon determining the predicted electrical breaker movement event has occurred.

EP 4 734 140 A1

**Description**

TECHNICAL FIELD

The present disclosure relates to circuit protection devices, and more particularly, techniques for reliably detecting electrical circuit breaker events based on handle movement characteristics of a circuit breaker.

BACKGROUND

Accurately determining when an Electrical Circuit Breaker (ECB) has tripped can be challenging in some circumstances. This is especially true if relying on a visual inspection of the breaker handle when the breakers are in large panels or in an area that is not well lighted. This problem is compounded because the tripped position of the electrical circuit breaker operating handle is very close to the "off" position.

Determining a state of an electrical circuit breaker based on movement characteristics provides challenges as well based on electrical circuit breaker operational environments that tend to be highly vibrational, electrical circuit breakers with a wide range of operation characteristics and ratings, various physical orientations of electrical circuit breakers, different operational types of electrical circuit breakers, and various electrical circuit breaker operations, such as a test trip, short circuit trip, and overload trip. This gives rise to a technical problem of accurately determining when a particular electrical circuit breaker event occurs based on various movement characteristics and discerning an actual event from other environmental or electrical circuit breaker operation.

SUMMARY

In one embodiment, a method and an apparatus include receiving Electrical Circuit Breaker (ECB) handle motion data from a sensor, generating an encoded motion vector using one or more motion characteristics from the received ECB handle motion data, generating a probability distribution of ECB events from the encoded motion vector and the one or more motion characteristics using a trained Machine Learning (ML) model, generating a prediction of an electrical breaker movement event based on the generated probability distribution of ECB events by identifying an ECB event with the highest probability from the trained ML model, and transmitting a signal, upon determining the predicted electrical breaker movement event has occurred.

In another embodiment, the method and apparatus further include a second sensor configured to receive ECB handle data. Further, the sensor is configured to measure one of acceleration, vibration, acoustic sound, light, or image. Additionally, an input is configured to acquire ECB handle data using a time triggered architecture. Further, the processor and method are configured to modify the trained ML using ECB handle motion data, and the electrical breaker handle movement event is classified as one of an acceleration data type or a shock data type.

In further embodiments, the method and apparatus count a data read event when the electrical breaker movement event is not met, and a processed movement profile is of the acceleration data type. Further, an acceleration data set is collected when the electrical breaker movement event is met, and a processed movement profile is of the acceleration data type. Additionally, a data read event is counted when the electrical breaker movement event is met, and a processed movement profile is of the shock data type. Further, a peak event is counted when the electrical breaker movement event is met, and a processed movement profile is of the shock data type. Additionally, the acquired motion data is one of velocity, acceleration, acoustic sound, light, or image pixel changes. Further, where transmitting comprises transmitting the signal to a management device.

In another embodiment, an apparatus includes receiving Electrical Circuit Breaker (ECB) handle motion data from a sensor, generating an encoded motion vector using one or more motion characteristics from the received ECB handle motion data, generating a prediction of an electrical breaker movement event based on a generated probability distribution of ECB events by identifying an ECB event with the highest probability from the trained ML model, and transmitting a signal, upon determining the predicted electrical breaker movement event has occurred.

BRIEF DESCRIPTION OF THE DRAWINGS

A more detailed description of the disclosure, briefly summarized above, may be had by reference to various embodiments, some of which are illustrated in the appended drawings. While the appended drawings illustrate select embodiments of this disclosure, these drawings are not to be considered limiting of its scope, for the disclosure may admit to other equally effective embodiments.

Identical reference numerals have been used, where possible, to designate identical elements that are common to the figures. However, elements disclosed in one embodiment may be beneficially utilized on other embodiments without specific recitation.

FIG. 1 is a block diagram illustrating an ECB event system configured to detect an electrical circuit breaker event.

FIG. 2 is a flow diagram illustrating an embodiment of a method for detecting an electrical circuit breaker event.

FIG. 3 is a block diagram illustrating an embodiment of an ECB event system architecture to detect an electrical circuit breaker event.

FIG. 4 is a flow diagram illustrating an embodiment of a state machine for detecting an electrical circuit breaker event.

FIG. 5 is a block diagram illustrating a system configured to train and deploy a Machine Learning (ML) model to detect an electrical circuit breaker event.

FIG. 6 is a flow diagram illustrating an embodiment of a method for detecting an electrical circuit breaker event.

DETAILED DESCRIPTION

Electrical Circuit Breakers (ECB) are commonly used electrical components to provide a safety mechanism to interrupt the electricity flowing in a circuit to prevent personal injuries, death, or property damages. An ECB will generally have an external switch or handle, which based on its position will provide an electrical path ("on"), electrical isolation ("off"), or in the event of an over current or other fault condition designed to interrupt the current but indicate a fault ("trip"). It is desirable for users to be able to determine the state of an ECB to take any necessary action to determine the state of a circuit.

Embodiments herein describe systems and methods for techniques for reliably detecting electrical circuit breaker events based on movement characteristics of a circuit breaker handle. These techniques are based in part on "A Lighted Visual Trip Indicator Module for Circuit Breakers" (WO 2022/094235) which provided for the selective activation of a light emitting device to indicate a current state of a circuit breaker.

Technical challenges exist with an ability to accurately detect specific mechanical vibration events from general mechanical vibration. Detection of specific events such as an ECB reset, turn on, turn off, and trip from an environment that is generally filled with vibration is a challenge. Further substantial variability exists in ECB's given ECB age, material fatigue, construction materials, previous events, and operational environment.

Previous solutions comparing a known ECB acceleration profile of the ECB handle with a newly acquired ECB acceleration profile does not provide an acceptable level of confidence for trip event detection and its performance may be described as erratic. When a resource limited processing unit is used, the limited computational power further restricts the application of the prior art solution. A novel method is proposed to analyze the breaker handle acceleration profiles using the Artificial Intelligence/Machine Learning (AI/ML) approach with encoding motion characteristic data as a motion vector to train a ML model using the data collected under all foreseeable application environments. This approach can be embedded into a resource limited processor to differentiate various breaker events. In various testing at least 90% confidence level for breaker trip event detection has been achieved.

Typical power source of the breaker trip indicator is a battery. The prior art solution (WO2022094235A1) uses signals from vibration switch to wake up the Micro Controller Unit (MCU). Both the MCU and accelerometer perform data acquisition and data processing to determine the event type. One drawback with this approach is that any vibration, such as speaking loudly, a truck passing-by, vibrational noise from nearby breakers or vibration generated by the electricity flow itself can wake up the MCU to process this fantom breaker event, which consumes power and shortens product lifetime. In a constant vibration condition, the trip indicator lifetime can be less than a year for a reasonable capacity battery. Our customers anticipate the devices of this class have 10 years of lifetime. Concepts of this disclosure address this issue using a novel approach of noise rejection to decide when to perform data acquisition and data processing to minimize the power consumption. When using this approach with a low-capacity battery such as a 100mAh, in the worst-case application condition, a product lifetime of ~3 years is projected. In the best case, the product has a lifetime of well over 10 years.

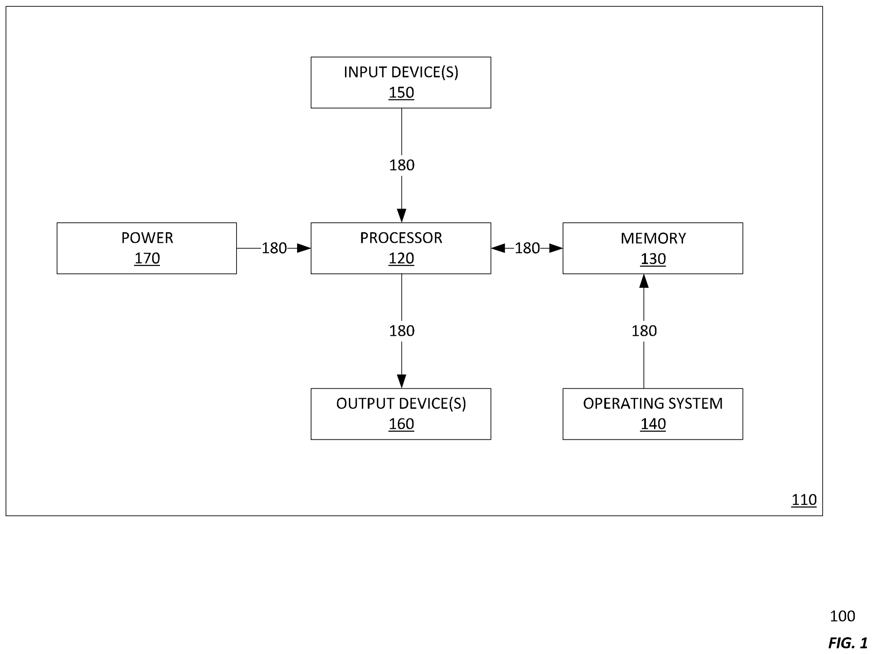

FIG. 1 is a block diagram illustrating an ECB event system configured to detect an electrical circuit breaker event, according to one embodiment described herein. As illustrated, the ECB event system 100 may contain several components that contain a processor 120, a memory 130, an operating system 140, an input device 150, an output device, and a power supply 170. It should be appreciated that one or more of each component may exist and the entire ECB event system 100 be in a single housing 110 or distributed among several housings. Considerations for the system should allow for an extended operational life and include low power consumption, field replaceability, and cost, among others.

It should be appreciated this disclosure contemplates an ECB event system 100 contained in a single housing 110 and being mounted to an external breaker handle, breaker chassis, load panel, or other surface which can receive inputs. It is further contemplated that an ECB event system 100 may be in communication with other ECB event systems 100 and in that way, a network of ECB systems may be deployed, and data collected across the network of ECB event system 100 devices and transmitted to a management device or system for further action.

Each processor 120 may be of various types and includes devices such as single chip microcontrollers such as the STMicroelectronics STM32G031 microcontroller. This processor 120 is responsible for storing and executing operational instructions for the system. This operational code may reside in the processor itself 120 or on a memory 130 external from the processor 120. An operating system 140 resides in the memory 130 either internal or external to the processor 120 and provides for the operation of the various tasks utilized for operating the system.

One or more inputs devices 150 are integrated into the system 100 to receive inputs from the surrounding environment. These input devices 150 include, but are not limited to, vibration switches, accelerometers, acoustic sound, light, or images. This disclosure contemplates the possibility of such input devices 150 not being integrated within a single housing of an ECB event system 110, but the possibility of receiving information from an external input device for further processing by the ECB event system 100. As with other components of the ECB event system 100, considerations for the ECB event system 100 to allow for an extended operational life include low power consumption and cost among others.

One or more output devices 160 are integrated into the ECB event system 100 to provide outputs, for example, to the environment, users, and connected management device. These output devices 160 include, but are not limited to, lights, such as LEDs, sound devices, such as piezo electric buzzers, or other digital outputs to provide signals to, for example, a management device. Error patterns from visible or audible sensors (e.g. Muticolored LED to indicate a condition, Morse Code visible from a LED, or audible from a piezo electric speaker) are contemplated for the ECB event system 100 to provide error conditions to a user. As with input devices 150, this disclosure contemplates the possibility of such output devices 160 not being integrated within a single housing of a system 110, but the possibility of receiving information from an external input device for further processing by the ECB event system 100. As with other components of the system, considerations for the system to allow for an extended operational life include low power consumption and cost among others.

Both wired and wireless communication interfaces are contemplated as part of this disclosure as output devices 160. These interfaces may include serial data bus interfaces such as I2C, SPI, parallel communication paths such as a data bus, and device specific interfaces such as 4-20 mA or 0-5V interfaces. Wireless support examples may include Wi-Fi, Bluetooth, RFID, or Zigbee. These interfaces are contemplated for user to ECB event system 100 communication (e.g. to upload new operational code or Machine Learning models directly to an ECB event system 100), ECB event system 100 to ECB event system 100 communication (e.g. to form a mesh of ECB event system 100 devices), or ECB event system 100 to management device (e.g. to report status or other data to a system to report or take further action on portions of an infrastructure such as the critical infrastructure of a data center.)

Further, communication from the output devices 160 from the ECB event system 100 to a management device (not shown) or other the ECB event systems 100 to create a network of the ECB event systems 100 are also contemplated. These functions may be supported in a hardware, firmware, or software functions, or some combination therein which may include one or more hardware, firmware, or software resources from the ECB event system 100.

A power 170 component either internal to the ECB event system 100, for example in the form of a battery or other charge storage mechanism, such as a capacitor, other energy harvesting mechanism, or external power connection is used to provide power to the various components of the ECB event system 100 depending on the purpose of the application. Various tasks of the operating system 140 may utilize one or more output devices 160 to indicate the general health of the power 170 of the ECB event system 100. As with other components of the system, considerations for the system to allow for an extended operational life include low power consumption and cost among others.

Various interfaces 180 are used to provide signals and data between the components of the ECB event system 100. These interfaces may include serial data bus interfaces such as I2C, SPI, parallel communication paths such as a data bus, device specific interfaces such as 4-20 mA, 0-5V interfaces. Both wired and wireless communication interfaces are contemplated as part of this disclosure. Further, communication from the output devices 160 from the ECB event system 100 to a management device or other the ECB event systems 100 to create a network of the ECB event systems 100 are also contemplated. These functions may be supported in hardware, firmware, software, or some combination therein which may include multiple resources of these types from the ECB event system 100.

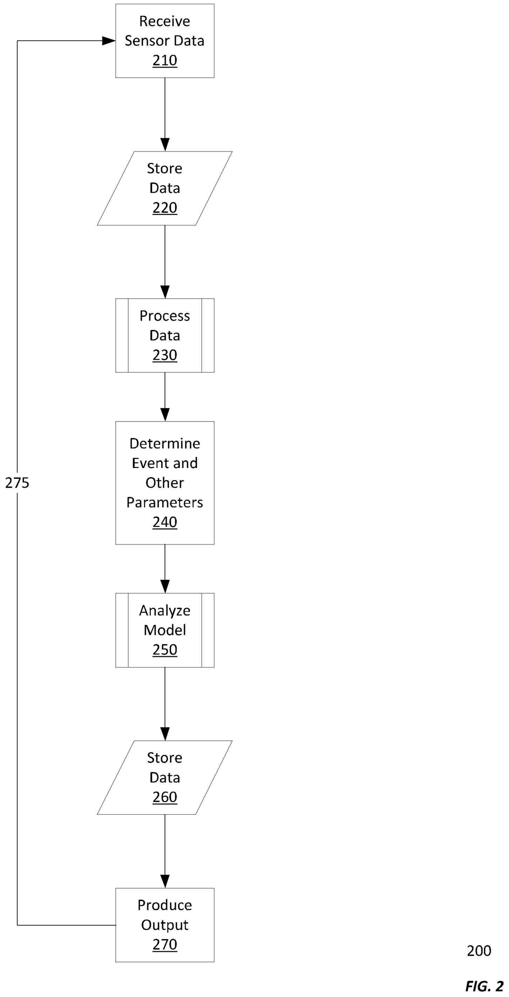

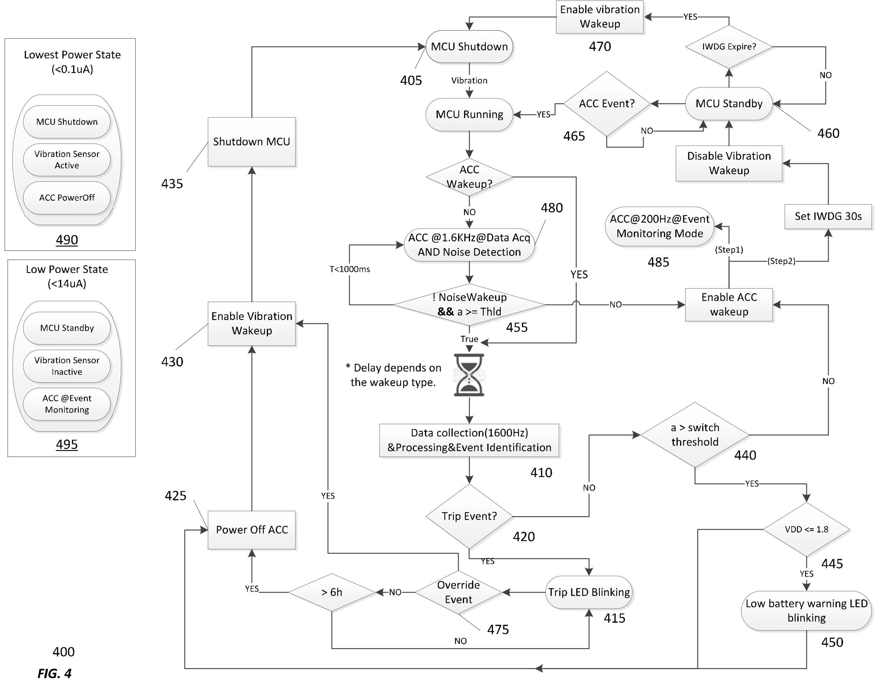

FIG. 2 is a flow diagram illustrating an embodiment of a method for detecting an electrical circuit breaker event 200, according to one embodiment described herein. During operation the ECB event system 100 will operate as a continuous state machine, with states such as standby, shut down, wake up, receive, process, and predict ECB events based on environmental data received by the ECB event system 100. Further detail to the operation of the state machine is illustrated in FIG. 4.

As illustrated, as the ECB event system 100 receives acceleration or other sensor data 210 from available input devices 150, data is stored generally as a time series, which is stored in a data store 220. It should be appreciated that the type and how the data is stored is dependent on the input device 150. Once the data acquisition is completed for a particular ECB event, the input data is processed 230 and uses the processed data to calculate one or more profiles of acceleration, velocity, and other parameters such as motion vector to determine an ECB event. Other parameters and data are input, retrieved, or calculated from the sensors, memory, or processor 240 and made available for use. An event profile, e.g., a motion vector based on this processed data is stored and analyzed 250 with other stored models to determine, for example, if an ECB event has occurred and the ECB event type. Results of the analysis are stored 260 and the ECB event system 100 produces an output to one or more of the output devices 160 to alert a user or management device of the status of the monitored ECB. It should be appreciated the operation of the ECB event system 100 is a continuous loop from producing an output 270, back to receiving sensor data 210 from the available input devices 150 via a feedback loop 275.

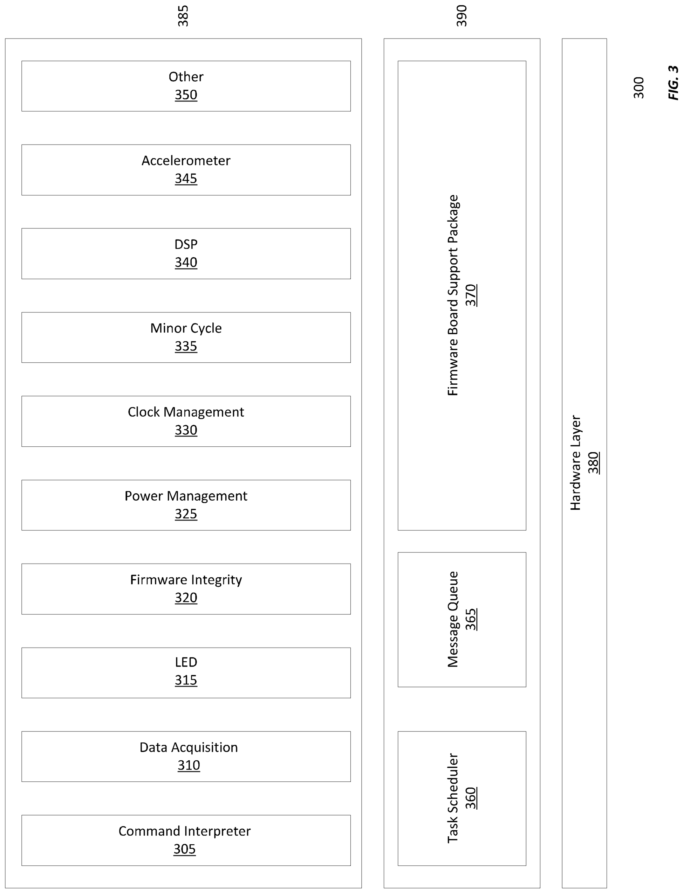

FIG. 3 is a block diagram illustrating an embodiment of a system architecture to detect an ECB event 300, according to one embodiment described herein. Such an architecture may run in a processor 120 or memory 130 as software on an operating system such as described by the operating system 140 on the ECB event system 100. There are two main components to the system architecture to detect an ECB event 300 that include an application layer 385 and kernel layer 390.

An application layer 385 is comprised of several tasks or services that provide functionality to the overall functionality of the ECB event system 100. Examples of the tasks include, but are not limited to, a command interpreter task 305 is responsible for receiving and executing commands in the ECB event system 100. Data acquisition task 310 is responsible for the data collection process from the input devices 150. LED task 315 is responsible for the control of the LED output. It should be appreciated other tasks are contemplated for other output device 160 types. A firmware integrity task 320 calculates checksums and otherwise provides run time integrity check of the operating system 140 and operational software.

Power management tasks 320 are responsible for the monitoring and management of aspects of power within the ECB event system 100. A substantial technical challenge is the proper management of power aspects of the ECB event system 100 by maximizing an operational power life to minimize replacement. Clock management 330 like power management 325 is an important aspect of the ECB event system 100 as power consumption is dependent on the clock frequency. In the ECB event system 100 the dynamic power consumed by CPU is approximately proportional to the CPU clock frequency, and to the square of the CPU power supply voltage, making clock management critical. Any static power consumption at the shutdown state of the processor is practically negligible since CPU is not running.

Like the clock management 330, the minor cycle manager 335 runs periodically, for example every 0.5ms, to acquire data and assist in operational state of the ECB event system 100. A Machine Learning (ML) module 340 processes the data collected by the data acquisition module 310 to assist in generating a breaker event profile in form of motion vector that is used to identify a breaker event. An accelerometer manager 345 is responsible for the control of the accelerometer input. It should be appreciated other tasks are contemplated for other input device 150 types. It should be appreciated there are other 350 application layer modules that correspond to other parts of the ECB event system 100.

A kernel layer 390 consists of a task scheduler 360 responsible for scheduling all software related tasks and operates periodically. A message queue 365 is used as a data store to logically couple portions of the system that produce and consume data. A firmware board support package 370 which provides functionalities for all the interfaces at the application layer 385 and provides access to the ECB event system 100 hardware, such as input devices 150, output devices 160, and their respective interfaces 180 such as, ADC, GPIO, I2C, or USART, either through direct function calls, callback functions, or message queues 365. All ECB event system 100 device specific applications reside in the application layer 385.

A hardware layer 380 serves as the physical layer to house, interconnect, and interface with the other modules described herein. It should be appreciated embodiments of this layer may include hardware, software, and firmware components which allow the interconnect of the system both physically and virtually. It may serve as an abstraction layer for one or more physical or virtual layers.

FIG. 4 is a flow diagram illustrating an embodiment of a state machine for detecting an electrical circuit breaker event 400, according to one embodiment described herein. Once powered the ECB event system 100 will operate continuously to determine if any ECB events have occurred.

Once the ECB event system 100 is reset or powered on, the operating system 140 is initialized and enters the shutdown state 490 where the processor 120 and various input devices are shutdown 405 to save power. If sufficient vibration is detected at an input device 150, the processor 120 wakes up to begin data acquisition and collect data 410, which may be time series or digital based on the input device 150 and mode of the ECB event system 100. As examples in the current system this state could be created by an accelerometer activity or a vibration wakeup event. As described herein, once an instantaneous threshold is met, data collection will begin. After completing the data acquisition, the processor 120 enters the data processing state, the end of which generates an LED indication, or other output 415 based on the detected breaker event.

Type and duration of the output, such as the LED, depends on the type of event detected. Once designated notification is provided at the output device 160, the processor 120 is shutdown 405. If there is additional vibration when the processor 120 is in the indicated state and providing an output, the event may be overridden 475.

When the device is in a vibration environment and woke up by the accelerometer 455 or other input device 150, if a vibration amplitude is not at a particular threshold to be considered as a breaker switch event, the ECB event system 100 transitions to the lower power (standby) mode 460. In this state ECB event system 100 is not woken up by the accelerometer or other input sensor while running at the low power acceleration monitoring mode 485 if a measured acceleration is not higher than a threshold. As one example, 2 - 6 g. In this way the ECB event system 100 rejects noise to avoid unnecessary data acquisition and processing to save power.

When the ECB event system 100 is operating in a vibration filled environment and is capable to be woken up by the vibration switch, or other input device 150, the ECB event system 100 must differentiate spurious noises from actual ECB events. To facilitate this differentiation, the vibration switch input into the processor 120 is transformed from an analog input into a digital input. The processor 120 reads this input state on a periodic basis, for example every 500μs, and stores the result into a bit array of size 32 using an unsigned 32-bit integer 480. In some embodiments, the bit array has a value of 0xFFFFFFFF for an ECB event while noise gives other values, for example 0xEEE123FF or 0x00000000. The ECB event system 100 utilizes 24 bits as the criterion to differentiate noise from breaker event. Once noise is detected as opposed to an ECB event, the ECB event system 100 enters the low power mode 495 by disabling data acquisition and processing functionality to save power. It should be appreciated, during data acquisition operations, an input delay of several milliseconds may be used to allow reliable detection of breaker switch or trip events.

When the ECB event system 100 is in the low power state 495, the ECB event system 100 may be woken up by either accelerometer or vibration switch, but not both. How the ECB event system 100 will wake up depends on the environment the ECB event system 100 is operating in. If the accelerometer does not sense acceleration higher than the pre-determined threshold for a time limit, for example, 10 - 30 seconds, the ECB event system 100 enters the lowest power mode 490, shutdowns the accelerometer, and sets the vibration wakeup mode 470 using the vibration switch, and places itself into much lower power mode (shutdown) 405. If the ECB event system 100 is woken up by the vibration switch and the ECB event system 100 finds it is a noise created wakeup, it places the ECB event system 100 into the accelerometer wake up mode 465.

If the device passes either vibration switch mode noise rejection or accelerometer noise rejection or both, the device considers that the event can be potentially a breaker event which can be reset, off, on or trip.

After identifying an ECB trip breaker event 420, the ECB event system 100 blinks the LED periodically 415 or activates another output device 160, to indicate the ECB status. This blinking, or other output lasts for a period, for example 6 hours, if not interrupted. After which time, the ECB event system 100 shutdowns the processor (120) 435 and enables the vibration switch wakeup 430.

When the ECB event system 100 is in the trip state which is signified by the LED blinking or other device output 415, the accelerometer ECB event detection is enabled. Therefore, this state can be interrupted another ECB event 475 such as a switch off to reset or a switch on to reset the trip state of the ECB.

After identifying an ECB switch event 440, the ECB event system 100 will verify if the battery voltage is less than a threshold, such as 1.8 VDC 445. If the voltage is below the threshold, the ECB event system 100 will blink LED three times, or another output to indicate a low power condition 450. Then the ECB event system 100 places the processor 120 into the low power mode 495, and powers off the accelerometer sensor(s) 425. If this state is not entered, the ECB event system 100 enables the accelerometer wakeup. This process will operate continuously to determine if any ECB events have occurred.

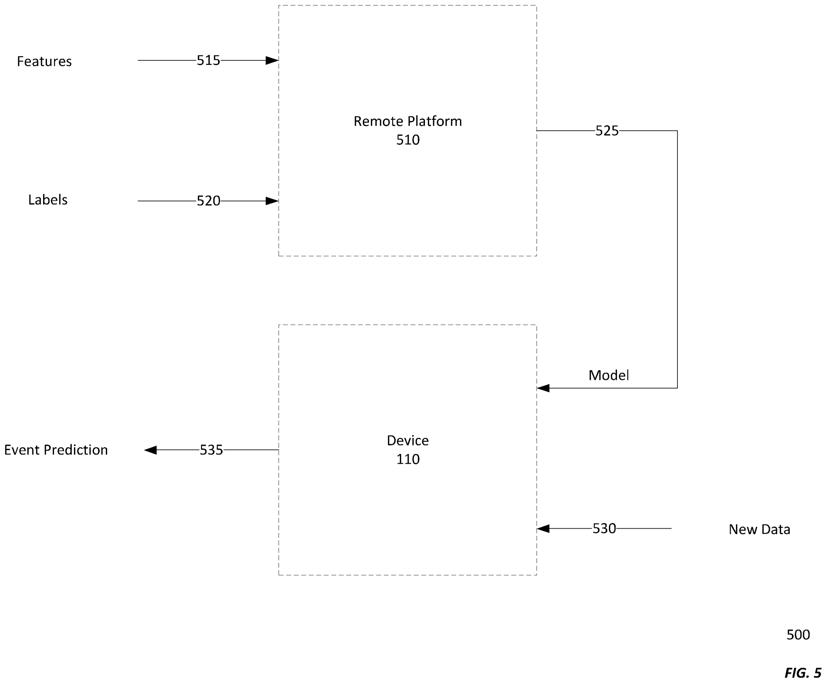

FIG. 5 is a block diagram illustrating a system configured to train and deploy a ML model to detect an electrical circuit breaker event 500, according to one embodiment described herein. Prior to commissioning an ECB event system 100 a ML model must be created and loaded into the device as the system itself is so computationally limited a model can not be calculated on the platform. Such a model is trained offline with a remote platform 510. This can be any general-purpose computing platform with enough computational resources to train the model. A ML model is trained with two types of inputs, features 515 and labels 520.

Features 515 are the outputs of the data acquisition module which collects data points of acceleration for a period of 100ms. In one example, 160 separate data points are collected. Labels 520 are recorded breaker events which again are collected for a period of 100ms. Similar to the labels 515 in the above example, 160 separate data points are collected. It should be appreciated that more or less data points may be used with the creation of the ML model as the remote platform 510 has the computational resources to create the ML model.

A model 525 is produced using, for example, 500-1000 sets of features 515 and labels 520, other larger and smaller sets of data are contemplated as part of this disclosure. A trained model is then embedded 525 into the ECB event system 100 as the system is commissioned. It should be appreciated that the computational resource limited ECB event system 100 is unable to process this amount of data to produce a ML model in real time.

In field operation, the present disclosure reduces or encodes a large time-series data of acceleration into a time independent low dimensional motion characteristic vector, i.e., motion vector, to offer an alternative representation of ECB event characteristics with much fewer data points. This reduced data set (new data 530), which can be acquired during operation of the ECB event system 100 can be used in conjunction with a trained ML model on the ECB event detection system 100 to determine an ECB event prediction 535 with extremely constrained computational resources such as those on the ECB event system 100. Example elements of the motion vector that are calculated using the time-series data of acceleration include, but are not limited to the following:

(a) No data count, which counts how many time-series acceleration data points have values below a given threshold since the processor 120 has woke up. (b) Taps (or shocks) where time-series data of acceleration can be used to measure taps, (i.e., acceleration peaks). (c) Breaker handle movement time where the ECB handle moves in a vibration manner and eventually comes to rest. The time between handle movement start and stop is defined as handle travel time. (d) Max difference of velocity in time-series data of velocity obtained by integrating acceleration, i.e., difference between max and min velocities. (e) Sum of acceleration. (f) Sum of absolute values of acceleration. (g) Sum of velocities.

The following illustrates one example of the ECB handle movement characteristics encoding process where 300 time-series data points are encoded in an eight-dimensional vector where each element can be considered as a feature in terms of ML.

$$\begin{bmatrix} a_1 \\ a_2 \\ \cdot \\ \cdot \\ \cdot \\ a_{299} \\ a_{300} \end{bmatrix} - - - - \rightarrow \begin{bmatrix} NoDataCount \\ MaxDiffV \\ HandleMT \\ MaxG \\ Taps \\ SumG \\ AbsSumG \\ SumV \end{bmatrix}$$

The above is just one illustration of a possible approach. Final numbers of encoded features and the number of time-series acceleration data points may vary and be selected by considering available processing power, computation resource availability, and the required level of confidence for detecting ECB events. In the above examples, as only eight elements of the encoded feature vector are selected due to the computational ability of the ECB event system 100, the ML model training can be calculated using logistic regression, neural network, support vector machine, *etc.* depending on the events detected need. It is also possible that our model is trained by "human learning" instead of machine learning, i.e., the model is trained by guessing the model by the trial and error with assistance a ML model. In other words, "human optimization" is used instead of the gradient descent algorithm in machine learning while the ML model can tell us the ultimate achievable event detection accuracy. The advantage of this approach is that the resulting code is very small and efficient computationally. It should be appreciated the available data is used to train the model. Training data set size will vary based on available resources. For example, 500-1000 sets of the encoded feature motion vectors and labels may be used to train the model and the trained model subsequently embedded into a resource limited Micro Controller Unit (MCU), for example, the STM32G031. It follows that less resource constrained devices will allow larger data sets and associated gains in functionality as a result.

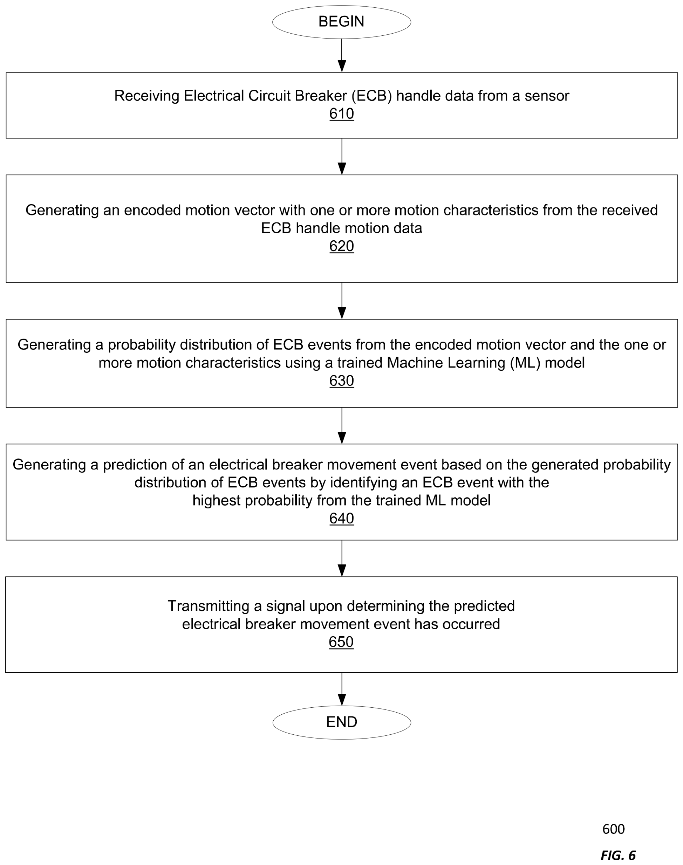

FIG. 6 is a flow diagram illustrating an embodiment of a method for detecting an electrical circuit breaker event 600, according to one embodiment described herein. As previously stated, this process will operate in a continuous state machine to determine if any ECB events have occurred. ECB events may include an on state, and off state, and a trip state. Other states are contemplated (e.g. a partial trip state) as part of this disclosure.

When the ECB event system 100 becomes active, it will receive data, such as ECB handle data, from one or more input devices 150 or sensors 610. This data may be acceleration, vibration, sound, light, or other input devices 150 to allow an enhanced collection of data from the environment the ECB event system 100 is operating in. Data from analog or digital sources as well as data, motion or otherwise, may be received by the ECB event system 100. Embodiments of the disclosure contemplate input devices that are external to the ECB event system 100 but can communicate with it via a wired or wireless connection. This data is also represented as the new data 530 input to the ECB event system 100.

This raw motion data is processed by the ECB event system 100 and one or more encoded motion characteristics are derived 620 as motion vector with characteristics such as, but not limited to, (a) No data count, (b) Taps (or shocks), (c) Breaker handle movement time, (d) Max difference in velocity, (e) Sum of acceleration, (f) Sum of absolute values of acceleration, (g) Sum of velocities, and (h) Classification of an event (a) thru (g). These characteristics alone or in combination with each other may themselves indicate an ECB trip state or may be used for further processing to determine with a higher confidence an ECB trip state has occurred.

One or more of the generated motion characteristics are processed as an input with a previously populated machine learning model for the ECB presently being monitored. Processing of the generated motion characteristics with the existing machine learning (ML) model generates an encoded motion vector 630. The ECB event system 100 then generates a prediction of an electrical breaker movement event based on the generated probability distribution of ECB events by identifying the ECB event with the highest probability from the trained ML model 640.

Based on the predicted ECB event of on, off, or trip, transmit a signal with that information to an output device 160, such as an LED, or digitally to a management device 650. Embodiments of this disclosure contemplate the standalone operation of a single ECB event system 100, multiple standalone ECB event systems 100, and communication intra ECB event system 100 to allow for a networked series of ECB event systems 100. Output from one or more ECB event systems 100 may be used as an input to other management devices to effectuate control over other equipment for example, such as electrical switch gear, cooling devices, or other critical data center equipment.

Embodiments further contemplate this communication may include a number of ECB event systems 100 that are capable of communicating wirelessly to each other in a mesh type configuration and further, communicate wirelessly to a management device to report data, status, or other information related to the management of each of the ECB event system 100 and how that information may relate to a larger system, such as a data center and its related critical infrastructure.

Examples of a management device may include, but are not limited to, a device such as a server configured to receive inputs from one or more devices, such as the ECB event system 100 which are configured to provide data. This data from a number of sensors or devices which have sensing capabilities are collected and processed to provide information on the array of sensors or devices to allow monitoring or control of the devices themselves or the environment they are configured to be a part of.

One example may be a management device, or commonly called a management system, in the form or one or more servers operating a program to receive, process, and provide data related to critical infrastructure devices for a data center. Devices in the network may monitor or control critical devices such as power distribution, cooling capacity, or computational loads and the management device serve to control these resources to optimize operations or provide redundant failover in the event of an outage.

With regard to the ECB event system 100, a management device may, for example, receive input that particular ECBs are in an "off" position and not providing power to particular infrastructure. With this data a management device may selectively route power from another source, reduce computational load on a server, or alert a suer to take or confirm these actions. It should be appreciated this management device may act autonomously form these device inputs or in concert with a user.

It should be appreciated there are a variety of scenarios contemplated and in no way should these few examples be limiting to the capabilities of a management device.

It should be appreciated embodiments of the disclosure contemplate sensors may only active when the ECB handle acceleration or velocity is higher than a predefined threshold. Further the ECB system 100 contemplates that a second sensor may be used to determine the likelihood of an ECB event in form of noise rejection in addition to wake up by the MCU. Further it is possible that only one of the sensors in a multiple sensor system is active at any given time to allow the MCU to enter a waking state.

Various power saving modes are contemplated to preserve battery power for the ECB system 100. For example, when there is not significant ECB handle motion, including acceleration and vibrations. Further, the electronics including processors and sensors contemplate a specific power saving mode and may be awaken by the sensors when there is significant ECB handle motion, including vibrations and accelerations. A low power mode may be entered after processing motion data if an ECB event is not detected. Self-monitoring the power source of the ECB system 100 is contemplated, and indicates low power by light, sound, or other communication method.

ECB events may be transmitted by light, sound, and digital data communication if an ECB event is detected. An event indication duration can be a predefined length, preprogramed, or at a duration determined by the event (e.g. critical events are indicated for a longer duration). When communication is complete, the device may enter a power saving mode. Embodiments of the disclosure contemplate these functions as highly configurable to accommodate a large array of communication choices for the given application.

In the preceding, reference is made to various embodiments. However, the scope of the present disclosure is not limited to the specific described embodiments. Instead, any combination of the described features and elements, whether related to different embodiments or not, is contemplated to implement and practice contemplated embodiments. Furthermore, although embodiments may achieve advantages over other possible solutions or over the prior art, whether a particular advantage is achieved by a given embodiment is not limiting of the scope of the present disclosure. Thus, the preceding aspects, features, embodiments, and advantages are merely illustrative and are not considered elements or limitations of the appended claims except where explicitly recited in a claim(s).

The various embodiments disclosed herein may be implemented as a system, method, or computer program product. Accordingly, aspects may take the form of an entirely hardware embodiment, an entirely software embodiment (including firmware, resident software, micro-code, *etc.)* or an embodiment combining software and hardware aspects that may all generally be referred to herein as a "circuit," "module" or "system." Furthermore, aspects may take the form of a computer program product embodied in one or more computer-readable medium(s) having computer-readable program code embodied thereon.

Any combination of one or more computer-readable medium(s) may be utilized. The computer-readable medium may be a non-transitory computer-readable medium. A non-transitory computer-readable medium may be, for example, but not limited to, an electronic, magnetic, optical, electromagnetic, infrared, or semiconductor system, apparatus, or device, or any suitable combination of the foregoing. More specific examples (a non-exhaustive list) of the non-transitory computer-readable medium can include the following: an electrical connection having one or more wires, a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing. Program code embodied on a computer-readable medium may be transmitted using any appropriate medium, including but not limited to wireless, wireline, optical fiber cable, RF, *etc.,* or any suitable combination of the foregoing.

Computer program code for carrying out operations for aspects of the present disclosure may be written in any combination of one or more programming languages. Moreover, such computer program code can execute using a single computer system or by multiple computer systems communicating with one another (e.g., using a local area network (LAN), wide area network (WAN), the Internet, etc.). While various features in the preceding are described with reference to flowchart illustrations and/or block diagrams, a person of ordinary skill in the art will understand that each block of the flowchart illustrations and/or block diagrams, as well as combinations of blocks in the flowchart illustrations and/or block diagrams, can be implemented by computer logic (e.g., computer program instructions, hardware logic, a combination of the two, *etc.)*. Generally, computer program instructions may be provided to a processor(s) of a general-purpose computer, special-purpose computer, or other programmable data processing apparatus. Moreover, the execution of such computer program instructions using the processor(s) produces a machine that can carry out a function(s) or act(s) specified in the flowchart and/or block diagram block or blocks.

The flowchart and block diagrams in the Figures illustrate the architecture, functionality and/or operation of possible implementations of various embodiments of the present disclosure. In this regard, each block in the flowchart or block diagrams may represent a module, segment, or portion of code, which comprises one or more executable instructions for implementing the specified logical function(s). It should also be noted that, in some alternative implementations, the functions noted in the block may occur out of the order noted in the figures. For example, two blocks shown in succession may, in fact, be executed substantially concurrently, or the blocks may sometimes be executed in the reverse order, depending upon the functionality involved. It will also be noted that each block of the block diagrams and/or flowchart illustration, and combinations of blocks in the block diagrams and/or flowchart illustration, can be implemented by special purpose hardware-based systems that perform the specified functions or acts, or combinations of special purpose hardware and computer instructions.

It is to be understood that the above description is intended to be illustrative, and not restrictive. Many other implementation examples are apparent upon reading and understanding the above description. Although the disclosure describes specific examples, it is recognized that the systems and methods of the disclosure are not limited to the examples described herein but may be practiced with modifications within the scope of the appended claims. Accordingly, the specification and drawings are to be regarded in an illustrative sense rather than a restrictive sense. The scope of the disclosure should, therefore, be determined with reference to the appended claims, along with the full scope of equivalents to which such claims are entitled.

**Claims**

1. An apparatus to detect electrical circuit breaker events, comprising:

   a processor; and
   a non-transitory computer-readable memory containing computer program code that, when executed by operation of the processor, performs operations comprising:

      receiving Electrical Circuit Breaker (ECB) handle motion data from a sensor;
      generating an encoded motion vector using one or more motion characteristics from the received ECB handle motion data;
      generating a probability distribution of ECB events from the encoded motion vector and the one or more motion characteristics using a trained Machine Learning (ML) model;
      generating a prediction of an electrical breaker movement event based on the generated probability distribution of ECB events by identifying an ECB event with the highest probability from the trained ML model; and
      transmitting a signal, upon determining the predicted electrical breaker movement event has occurred.

2. The apparatus of claim 1, further comprising a second sensor configured to receive ECB handle data.

3. The apparatus of claim 1 or 2, wherein the sensor is configured to measure one of acceleration, vibration, acoustic sound, light, or image.

4. The apparatus of claim 1, 2 or 3, further comprising an input configured to acquire ECB handle data using a time triggered architecture.

5. A method of detecting electrical circuit breaker events, comprising:

   receiving Electrical Circuit Breaker (ECB) handle data from a sensor;
   generating an encoded motion vector with one or more motion characteristics from the received ECB handle motion data;

generating a probability distribution of ECB events from the encoded motion vector and the one or more motion characteristics using a trained Machine Learning (ML) model; generating a prediction of an electrical breaker movement event based on the generated probability distribution of ECB events by identifying an ECB event with the highest probability from the trained ML model; and transmitting a signal upon determining the predicted electrical breaker movement event has occurred.

6. The method of claim 5, wherein the method further comprises modifying the trained ML using ECB handle motion data.

7. The method of claim 5 or 6, wherein the electrical breaker movement event is classified as one of an acceleration data type or a shock data type.

8. The method of any one of claims 5 - 7, wherein a data read event is counted when the electrical breaker movement event is not met and a processed movement profile is of the acceleration data type.

9. The method of claim 5 - 8, wherein an acceleration data set is collected when the electrical breaker movement event is met and a processed movement profile is of the acceleration data type.

10. The method of claim 5 - 9, wherein a data read event is counted when the electrical breaker movement event is met and a processed movement profile is of the shock data type.

11. The method of claim 5 - 10, wherein a peak event is counted when the electrical breaker movement event is met and a processed movement profile is of the shock data type.

12. The method of claim 5 - 11, wherein the acquired motion data is one of velocity, acceleration, acoustic sound, light, or image pixel changes.

13. The method of claim 5 - 12, wherein transmitting comprises transmitting the signal to a management device.

14. An apparatus to detect electrical circuit breaker events, comprising:

   a processor; and
   a non-transitory computer-readable memory containing computer program code that, when executed by operation of the processor, performs operations comprising:

receiving Electrical Circuit Breaker (ECB) handle motion data from a sensor; generating an encoded motion vector using one or more motion characteristics from the received ECB handle motion data; generating a prediction of an electrical breaker movement event based on a probability distribution of ECB events by identifying an ECB event with the highest probability from a trained ML model; and transmitting a signal, upon determining the predicted electrical breaker movement event has occurred.

INPUT DEVICE(S) 150

POWER 170

PROCESSOR 120

MEMORY 130

OPERATING SYSTEM 140

OUTPUT DEVICE(S) 160

180

110

100

**FIG. 1**

Receive
Sensor Data
210

Store
Data
220

Process
Data
230

Determine
Event and
Other
Parameters
240

275

Analyze
Model
250

Store
Data
260

Produce
Output
270

200

FIG. 2

385

| Other |
| --- |
| 350 |

| Accelerometer |
| --- |
| 345 |

| DSP |
| --- |
| 340 |

| Minor Cycle |
| --- |
| 335 |

| Clock Management |
| --- |
| 330 |

| Power Management |
| --- |
| 325 |

| Firmware Integrity |
| --- |
| 320 |

| LED |
| --- |
| 315 |

| Data Acquisition |
| --- |
| 310 |

| Command Interpreter |
| --- |
| 305 |

390

| Firmware Board Support Package |
| --- |
| 370 |

| Message Queue |
| --- |
| 365 |

| Task Scheduler |
| --- |
| 360 |

| Hardware Layer |
| --- |
| 380 |

300

*FIG. 3*

**FIG. 4**

400

14

EP 4 734 140 A1

Features

Labels

Remote Platform
510

515

520

525

Model

Device
110

530

New Data

535

Event Prediction

500

*FIG. 5*

```
                              ┌──────────┐
                              │  BEGIN   │
                              └────┬─────┘
                                   │
                                   ▼
┌─────────────────────────────────────────────────────────────────────┐
│        Receiving Electrical Circuit Breaker (ECB) handle data          │
│                        from a sensor                                   │
│                           610                                          │
└────────────────────────────────┬──────────────────────────────────────┘
                                  │
                                  ▼
┌─────────────────────────────────────────────────────────────────────┐
│   Generating an encoded motion vector with one or more motion          │
│   characteristics from the received ECB handle motion data             │
│                           620                                          │
└────────────────────────────────┬──────────────────────────────────────┘
                                  │
                                  ▼
┌─────────────────────────────────────────────────────────────────────┐
│   Generating a probability distribution of ECB events from the         │
│   encoded motion vector and the one or more motion characteristics     │
│   using a trained Machine Learning (ML) model                          │
│                           630                                          │
└────────────────────────────────┬──────────────────────────────────────┘
                                  │
                                  ▼
┌─────────────────────────────────────────────────────────────────────┐
│   Generating a prediction of an electrical breaker movement event      │
│   based on the generated probability distribution of ECB events by     │
│   identifying an ECB event with the highest probability from the       │
│   trained ML model                                                     │
│                           640                                          │
└────────────────────────────────┬──────────────────────────────────────┘
                                  │
                                  ▼
┌─────────────────────────────────────────────────────────────────────┐
│   Transmitting a signal upon determining the predicted electrical      │
│   breaker movement event has occurred                                  │
│                           650                                          │
└────────────────────────────────┬──────────────────────────────────────┘
                                  │
                                  ▼
                              ┌──────────┐
                              │   END    │
                              └──────────┘
```

600

*FIG. 6*

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 343 289 A1 (SCHNEIDER ELECTRIC IND SAS [FR]) 27 March 2024 (2024-03-27) | 1,4-7, 13,14 | INV. H01H11/00 |
| Y | * paragraph [0017] - paragraph [0108] * ----- | 2,3,8-12 | H01H71/04 |
| Y | EP 2 549 610 B1 (SIEMENS INDUSTRY INC [US]) 31 August 2016 (2016-08-31) * paragraph [0020] - paragraph [0039] * ----- | 2,3,12 | ADD. G06N7/01 H02H1/00 G06N20/00 |
| Y | US 2023/033088 A1 (BOYACI AYDIN [DE] ET AL) 2 February 2023 (2023-02-02) * paragraph [0022] - paragraph [0041] * ----- | 8-10 | |
| Y | WO 2016/206056 A1 (STATE GRID CORP CHINA [CN]; STATE GRID BEIJING ELECTRIC POWER CO [CN]) 29 December 2016 (2016-12-29) * paragraph [0014] - paragraph [0117] * ----- | 11 | |

**TECHNICAL FIELDS
SEARCHED     (IPC)**

H01H

The present search report has been drawn up for all claims

| Place of search | Date of completion of the search | Examiner |
|---|---|---|
| Munich | 26 February 2026 | Abdelmoula, Amine |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.........................................................................................
& : member of the same patent family, corresponding
    document

EPO FORM 1503 03.82 (P04C01)

2

## ANNEX TO THE EUROPEAN SEARCH REPORT
## ON EUROPEAN PATENT APPLICATION NO.

EP 25 20 7283

This annex lists the patent family members relating to the patent documents cited in the above-mentioned European search report.
The members are as contained in the European Patent Office EDP file on
The European Patent Office is in no way liable for these particulars which are merely given for the purpose of information.

26-02-2026

| Patent document cited in search report | | Publication date | Patent family member(s) | | Publication date |
|---|---|---|---|---|---|
| EP 4343289 | A1 | 27-03-2024 | CN | 117763324 A | 26-03-2024 |
| | | | EP | 4343289 A1 | 27-03-2024 |
| | | | FR | 3140165 A1 | 29-03-2024 |
| | | | US | 2024372353 A1 | 07-11-2024 |
| EP 2549610 | B1 | 31-08-2016 | CA | 2783227 A1 | 20-01-2013 |
| | | | CN | 102891043 A | 23-01-2013 |
| | | | EP | 2549610 A2 | 23-01-2013 |
| | | | US | 2013021163 A1 | 24-01-2013 |
| US 2023033088 | A1 | 02-02-2023 | CN | 115700388 A | 07-02-2023 |
| | | | EP | 4124874 A1 | 01-02-2023 |
| | | | US | 2023033088 A1 | 02-02-2023 |
| WO 2016206056 | A1 | 29-12-2016 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2022094235 A

- WO 2022094235 A1